# EUROPEAN PATENT SPECIFICATION

(11) **EP 2 604 724 B1**
(45) Date of publication and mention of the grant of the patent: **25.02.2015**
(21) Application number: 11816641.2
(22) Date of filing: 12.08.2011
(51) Int. Cl.: C09K 13/08, H01L 31/0236, H01L 21/02, C09K 13/02

(54) **TEXTURE-ETCHANT COMPOSITION FOR CRYSTALLINE SILICON WAFER AND METHOD FOR TEXTURE-ETCHING (2)**
TEXTUR-ÄTZMITTEL FÜR KRISTALLINE SILIZIUM-WAFER UND TEXTUR-ÄTZVERFAHREN (2)
COMPOSITION D'AGENT DE GRAVURE POUR TEXTURATION DESTINÉE À UNE PLAQUETTE DE SILICIUM CRISTALLIN ET PROCÉDÉ DE GRAVURE POUR TEXTURATION (2)

(30) Priority: 12.08.2010 KR 20100077622
(43) Date of publication of application: 19.06.2013
(73) Proprietor: Dongwoo Fine-Chem Co., Ltd., Jeollabuk-do 570-140 (KR)
(72) Inventor: HONG, Hyung-Pyo, Iksan-si Jeollabuk-do 570-140 (KR); LEE, Jae-Youn, Iksan-si Jeollabuk-do 570-140 (KR); LIM, Dae-Sung, Iksan-si Jeollabuk-do 570-140 (KR)
(74) Representative: Prinz & Partner mbB
(86) International application number: PCT/KR2011/005948
(87) International publication number: WO 2012/021025

(56) References cited:
- EP-A1- 2 015 351
- WO-A1-2009/072438
- KR-A- 20080 104 030
- KR-A- 20090 102 508
- US-A1- 2010 112 728
- RUDERISCH A ET AL: "Synthesis and characterization of a novel resorcinarene-based stationary phase bearing polar headgroups for use in reversed-phase high-performance liquid chromatography", JOURNAL OF CHROMATOGRAPHY, ELSEVIER SCIENCE PUBLISHERS B.V, NL, vol. 1095, no. 1-2, 18 November 2005 (2005-11-18), pages 40-49, XP027722766, ISSN: 0021-9673 [retrieved on 2005-11-18]
- DATABASE WPI Week 200931 Thomson Scientific, London, GB; AN 2009-G79338 XP002714820, & CN 101 392 376 A (HITACHI METALS LTD) 25 March 2009 (2009-03-25) -& KR 2009 0030225 A (NAGASE CHEMTEX CORP [JP]; HITACHI METALS LTD [JP]) 24 March 2009 (2009-03-24)

## Description

### BACKGROUND OF THE INVENTION

### 1. Technical Field

The present invention relates to an etching composition for texturing a crystalline silicon wafer and a method of etching a crystalline silicon wafer using the etching composition. More particularly, the present invention relates to an etching composition for texturing a crystalline silicon wafer, which can uniformly texture the surface of a crystalline silicon wafer in a fine pyramid shape to obtain high absorbance, and to a method of etching a crystalline silicon wafer using the etching composition.

### 2. Description of the Related Art

Worldwide, novel renewable energy sources, which are new power sources, have been actively introduced because of fossil energy depletion, rises in the price of oil, climate change, environmental problems and the like. Currently, examples of novel renewable energy sources, which are used as alternatives to source of fossil fuel energy, include solar light, solar heat, wind force, biomass, fuel cells, water power, and the like. Among them, solar energy generation using a solar cell is spreading with the most activity.

A solar cell is a photoelectric cell that converts solar energy into electric energy. Examples of photoelectric cells include a selenium photoelectric cell using the contact between a metal and a semiconductor, a copper sulfite photoelectric cell, a crystalline silicon photoelectric cell using the principle of a P-N junction semiconductor, and the like. Crystalline silicon photoelectric cells are made into a P-N junction semiconductor substrate fabricated by diffusing phosphorus into the surface of a P-type silicon semiconductor, in which boron is added to silicon, to attach an N-type silicon semiconductor to the P-type silicon semiconductor. When an electric field is formed by the P-N junction in such a P-N junction semiconductor substrate and the substrate is irradiated with light such as solar light, electrons (-) and holes (+) are excited, and thus move freely. In this case, when electrons (-) and holes (+) come into the electric field formed by the P-N junction, electrons (-) reach an N-type semiconductor, and holes (+) reach a P-type semiconductor. Here, when electrodes are formed on the surface of the P-type semiconductor and the surface of the N-type semiconductor and electrons flow to an external circuit, electric current is generated. Owing to this principle, solar energy is converted into electric energy. Therefore, in order to maximize the electrical power of a silicon photoelectric cell per unit area, it is required to decrease the reflectance of the silicon photoelectric cell and to maximize its absorbance. For this purpose, the surface of a silicon wafer for a solar cell is textured in a fine pyramid shape and is treated with an antireflective film. The silicon surface textured in the fine pyramid shape decreases the reflectance of incident light across a wide band of wavelengths to increase the intensity of previously-absorbed light, thereby increasing the performance, that is, the efficiency of a solar cell. To date, various methods for texturing the surface of a silicon wafer in a fine pyramid shape have been researched and developed. Specific examples thereof are as follows.

U.S. Patent. No. 4,137,123 discloses a silicon texturing etchant in which 0.5 to 10 wt% of silicon is dissolved in an anisotropic etchant including 0 to 75 wt% of ethylene glycol, 0.05 to 50 wt% of potassium hydroxide and residual deionized water. However, when this silicon texturing etchant is used, there is a problem in that the formation of pyramids on a silicon surface is poor, so that reflectance increases, thereby decreasing the efficiency of a solar cell.

European Patent Publication No. 0477424A1 discloses a texture etching method accompanying an aerating process wherein oxygen is supplied to a texture etching solution in which silicon is dissolved in a solution including ethylene glycol, potassium hydroxide and residual deionized water. However, when this texture etching method is used, there are problems of pyramids being poorly formed on the silicon surface, so that reflectance increases, thereby decreasing the efficiency of the solar cell, and in that an aerator must be additionally provided.

Korean Patent Publication No. 1997-0052617 discloses a texture etching solution including 0.5 to 5 vol% of a potassium hydroxide solution, 3.0 to 20 vol% of isopropyl alcohol and 75 to 96.5 vol% of deionized water. Further, U.S. Patent. No. 6,451,218 discloses a texture etching solution including an alkaline compound, isopropanol, water-soluble alkaline ethylene glycol and residual deionized water. However, these texture etching solutions are problematic in that, since isopropyl alcohol has a low boiling point, isopropyl alcohol must be additionally supplied during a texturing process, so that a large amount of isopropyl alcohol is used, with the result that they are disadvantageous in terms of productivity and economic efficiency, and in that the temperature gradient of the chemical occurs because isopropyl alcohol is supplied during the texturing process, thus deteriorating the texture uniformity of the surface of a silicon wafer.

As described above, the conventional texturing process of a silicon wafer was problematic in that, when only potassium hydroxide is used, a silicon wafer is anisotropically etched, thus increasing the reflectance of the silicon wafer. In order to solve this problem, potassium hydroxide was used in combination with isopropyl alcohol. However, even in this case, there was a problem in that, since the texturing process is conducted at 75 to 80°C, isopropyl alcohol having a boiling point of 80°C is volatilized, so that isopropyl alcohol must be additionally supplied during the texturing process, with the result that there is a temperature gradient in the chemical, thereby deteriorating the texture uniformity of the surface of the silicon wafer.

### SUMMARY OF THE INVENTION

Accordingly, the present invention has been devised to solve the above-mentioned problems, and an object of the present invention is to provide an etching composition for texturing a crystalline silicon wafer, which can form a uniform texture on the surface of a crystalline silicon wafer in a fine pyramid shape to easily absorb light, which can remarkably reduce the usage of the etching composition compared to that of a conventional etching composition using a cyclic compound having a high boiling point so that a larger number of crystalline silicon wafers can be treated, which does not require additional silicon particles for forming fine pyramids, and does not require to introduce chemical during an aerating process (oxygen supply process) or a texturing process, and to a method of etching a crystalline silicon wafer using the etching composition.

In order to accomplish the above object, an aspect of the present invention provides an etching composition for texturing a crystalline silicon wafer in accordance with claim 1.

Another aspect of the present invention provides a method of etching a crystalline silicon wafer using the etching composition in accordance with claim 7.

### BRIEF DESCRIPTION OF THE DRAWINGS

The above and other objects, features and advantages of the present invention will be more clearly understood from the following detailed description taken in conjunction with the accompanying drawings, in which:
FIG. 1 is an optical micrograph showing a texture of a crystalline silicon wafer treated with an etching composition of Example 6;
FIG. 2 is an SEM photograph showing a surface of a crystalline silicon wafer textured with the etching composition of Example 6; and
FIG. 3 is an SEM photograph showing a section of a crystalline silicon wafer textured with the etching composition of Example 6.

### DESCRIPTION OF THE PREFERRED EMBODIMENTS

Hereinafter, preferred embodiments of the present invention will be described in detail with reference to the attached drawings.

The present invention provides an etching composition for texturing a crystalline silicon wafer and a method of etching a crystalline silicon wafer using the etching composition. More particularly, the present invention provides an etching composition for texturing a crystalline silicon wafer, which can uniformly texture the surface of a crystalline silicon wafer in a fine pyramid shape to obtain high absorbance, and to a method of etching a crystalline silicon wafer using the etching composition.

The etching composition for texturing a crystalline silicon wafer according to the present invention includes (A) an alkaline compound; (B) a cyclic compound having a boiling point of 100°C or more; (C) a fluorine-based surfactant; and (D) water.

The alkaline compound (A) included in the etching composition of the present invention is included in an amount of 0.1 to 20 wt%, preferably 1 to 5 wt%, based on the total amount of the composition. When the amount of the alkaline compound is present within the above range, the surface of a crystalline silicon wafer is etched.

The alkaline compound is any one selected from the group consisting of potassium hydroxide, sodium hydroxide, ammonium hydroxide, tetrahydroxymethyl ammonium, tetrahydroxyethyl ammonium, and mixtures thereof. More preferably, the alkaline may be potassium hydroxide and/or sodium hydroxide.

The cyclic compound (B) having a boiling point of 100°C or more, preferably 150°C to 400°C, included in the etching composition of the present invention is included in an amount of 0.1 to 50 wt%, preferably 2 to 10 wt%, based on the total amount of the composition. When the amount of the cyclic compound is present within the above range, the cyclic compound improves the wettability of the surface of a crystalline silicon wafer, and thus prevents the surface thereof from being overetched by the alkaline compound, thereby forming uniform fine pyramids on the surface thereof. Further, the cyclic compound serves to prevent the occurrence of a bubble stick phenomenon by rapidly reducing the etched and dissolved hydrogen bubbles.

Here, the cyclic compound is a cyclic compound of C₄ to C₁₀ or a heterocyclic compound of C₄ to C₁₀ including one or more heterogeneous elements selected from among N, O and S.

The cyclic compound having a boiling point of 100°C or more is one or more selected from the group consisting of piperazines, morpholines, pyridines, piperidines, piperidones, pyrrolidines, pyrrolidones, imidazolidinones, furans, anilines, toluidines, and lactones. Specific examples of the cyclic compound having a boiling point of 100°C or more may include piperazine, N-methylpiperazine, N-ethylpiperazine, hydroxyethylpiperazine, N-(2-aminoethyl)piperazine, N,N'-dimethylpiperazine, morpholine, N-methylmorpholine, N-ethylmorpholine, N-phenylmorpholine, N-cocomorpholine, N-(2-aminoethyl)morpholine, N-(2-cyanoethyl)morpholine, N-(2-hydroxyethyl)morpholine, N-(2-hydroxypropyl)morpholine, N-acetylmorpholine, N-formylmorpholine, N-methymorpholine-N-oxide, picoline, N-methylpiperidine, 3,5-dimethylpiperidine, N-ethylpiperidine, N-(2-hydroxyethyl)piperidine, N-methyl-4-piperidone, N-vinyl-2-piperidone, N-methylpyrrolidine, N-methylpyrrolidone, N-ethyl-2-pyrrolidone, N-isopropyl-2-pyrrolidone, N-butyl-2-pyrrolidone, N-tert-butyl-2-pyrrolidone, N-hexyl-2-pyrrolidone, N-octyl-2-pyrrolidone, N-benzyl-2-pyrrolidone, N-cyclohexyl-2-pyrrolidone, N-vinly-2-pyrrolidone, N-(2-hydroxyethyl)-2-pyrrolidone, N-(2-methoxyethyl)-2-pyrrolidone, N-(2-methoxypropyl)-2-pyrrolidone, N-(2-ethoxyethyl)-2-pyrrolidone, N-methylimidazolidinone, dimethylimidazolidinone, N-(2-hydroxyethyl)-ethyleneurea, tetrahydrofuran, tetrahydrofurfurylalcohol, N-methylaniline, N-ethylaniline, N,N-dimethylaniline, N-(2-hydroxyethyl)aniline, N,N-bis-(2-hydroxyethyl)aniline, N-ethyl-N-(2-hydroxyethyl)aniline, N,N-diethyl-o-toluidine, N-ethyl-N-(2-hydroxyethyl)-m-toluidine, dimethylbenzylamine, γ-butyrolactone, tolyltriazole, 1,2,3-benzotriazole, 1,2,3-triazole, 1,2,4-triazole, 3-amino-1,2,4-triazole, 4-amino-4H-1,2,4-triazole, 1-hydroxybenzotriazole, 1-methylbenzotriazole, 2-methylbenzotriazole, 5-methylbenzotriazole, benzotriazole-5-carbonate, nitrobenzotriazole, and 2-(2H-benzotriazol-2-yl)-4,6-di-tert-butylphenol.

The fluorine-based surfactant (C) included in the etching composition of the present invention is included in an amount of 0.000001 to 10 wt%, preferably 0.0001 to 1 wt%, based on the total amount of the composition. When the amount of the fluorine-based surfactant is present within the above range, the fluorine-based surfactant decreases the surface tension of the etching composition together with the cyclic compound having a boiling point of 100°C or more to improve the wettability of the surface of a crystalline silicon wafer, thereby preventing the surface thereof from being overetched by the alkaline compound.

The fluorine-based surfactant may be one or more selected from the group consisting of anionic fluorine-based surfactants, cationic fluorine-based surfactants, amphoteric ionic fluorine-based surfactants, and nonionic fluorine-based surfactants. Specific examples of the fluorine-based surfactant may include anionic fluorine-based surfactants including perfluoroalkyl carboxylates, perfluoroalkyl sulfonates, perfluoroalkyl sulfates, and perfluoroalkyl phosphates; cationic fluorine-based surfactants including perfluoroalkyl amines and perfluoroalkyl quaternary ammoniums; amphoteric ionic fluorine-based surfactants including perfluoroalkyl carboxybetaine and perfluoralkyl sulfobetaine; and nonionic fluorine-based surfactants including fluoroalkyl polyoxyethylene and perfluoroalkyl polyoxyethylene.

The water (D) included in the etching composition of the present invention is included as a remainder such that the total amount of the composition is 100 wt%. The water may be deionized distilled water, and the deionized distilled water is used for a semiconductor process and has a specific resistance of 18 MΩ/cm or more.

The etching composition of the present invention may further include: (E) a silica-containing compound. The silica-containing compound may be included in an amount of 0.00001 to 10 wt%, preferably 0.0001 to 1 wt%, based on the total amount of the composition. When the amount of the silica-containing compound is present within the above range, the silica-containing compound is physically adsorbed on the surface of a crystalline silicon wafer, and thus serves as a mask, thereby forming pyramids on the surface thereof.

The silica-containing compound may be one or more selected from the group consisting of powdered silica, silica-containing colloidal solutions, and liquid metal silicates. Specific examples of the silica-containing compound my include powdered silica; a colloidal silica solution stabilized with Na₂O; a colloidal silica solution stabilized with K₂O; a colloidal silica solution stabilized with acidic liquid; a colloidal silica solution stabilized with NH₃; a colloidal silica solution stabilized with an organic solvent such as ethyl alcohol, propyl alcohol, ethylene glycol, methyl ethyl ketone (MEK) or methyl isobutyl ketone (MIBK); liquid sodium silicate; liquid potassium silicate; and liquid lithium silicate.

The etching composition of the present invention may be applied to any of dipping-type, spraying-type and single sheet-type etching processes.

Further, the present invention provides a method of etching a crystalline silicon wafer by either or both dipping and/or spraying at 50 ~ 100°C for 30 seconds - 60 minutes using the above etching composition including (A) 0.1 to 20 wt% of an alkaline compound, (B) 0.1 to 50 wt% of a cyclic compound having a boiling point of 100°C or more, (C) 0.000001 to 10 wt% of a fluorine-based surfactant, and (D) water.

Hereinafter, the present invention will be described in more detail with reference to the following Examples. However, these Examples are set forth to illustrate the present invention, and the scope of the present invention is not limited to these Examples. The following Examples may be modified and changed by those skilled in the art within the scope of the present invention.

### Examples 1 to 12 and Comparative Examples 1 to 4: Preparation of etching composition for texturing crystalline silicon wafer

Etching compositions for texturing a crystalline silicon wafer of Examples 1 to 12 and Comparative Examples 1 to 4 were prepared according to the components and composition ratios given in Table 1 below.

**[Table 1]**

| | Alkaline compound | | Cyclic compound | | Fluorine-based surfactant | | Deionized distilled water |
|---|---|---|---|---|---|---|---|
| | kind | content (wt%) | kind | content (wt%) | kind | content (wt%) | |
| Ex. 1 | KOH | 2 | NMP | 5 | PFAS | 0.005 | remainder |
| Ex. 2 | KOH | 2 | NMM | 5 | PFAS | 0.005 | remainder |
| Ex. 3 | KOH | 2 | NMP | 5 | PFAP | 0.005 | remainder |
| Ex. 4 | KOH | 2 | NMM | 5 | PFAP | 0.005 | remainder |
| Ex. 5 | KOH | 2 | NMP | 6.5 | PFAS | 0.001 | remainder |
| | | | AEP | 0.5 | | | |
| Ex. 6 | KOH | 2 | NMP | 4.9 | PFAS | 0.001 | remainder |
| | | | GBL | 0.1 | | | |
| Ex. 7 | KOH | 2 | NMM | 6.5 | PFAS | 0.001 | remainder |
| | | | AEP | 0.5 | | | |
| Ex. 8 | KOH | 2 | NMM | 4.9 | PFAS | 0.001 | remainder |
| | | | GBL | 0.1 | | | |
| Ex. 9 | KOH | 2 | NMP | 6.5 | PFAP | 0.001 | remainder |
| | | | AEP | 0.5 | | | |
| Ex. 10 | KOH | 3 | NMP | 6.5 | PFAP | 0.001 | remainder |
| | | | AEP | 0.5 | | | |
| Ex. 11 | KOH | 4 | NMP | 6.5 | PFAP | 0.001 | remainder |
| | | | AEP | 0.5 | | | |
| Ex. 12 | NaOH | 2 | NMP | 6.5 | PFAS | 0.001 | remainder |
| | | | AEP | 0.5 | | | |
| Comp. Ex. 1 | KOH | 1.5 | IPA | 5 | - | - | remainder |
| Comp. Ex. 2 | KOH | 1.5 | EG | 5 | - | - | remainder |
| Comp. Ex. 3 | KOH | 1.5 | MDG | 5 | - | - | remainder |
| Comp. Ex. 4 | KOH | 1.5 | MEA | 5 | - | - | remainder |

| | | | | | | | |
|---|---|---|---|---|---|---|---|
| note) KOH: potassium hydroxide NaOH: sodium hydroxide NMP: N-methylpyrrolidone NMM: N-methylmorpholine AEP: aminoethylpiperazine GBL: y-butyrolactone IPA: isopropyl alcohol EG: ethylene glycol MDG: methyldiglycol MEA: monoethylamine PFAS: perfluoroalkyl sulfate PFAP: perfluoroalkyl phosphate | | | | | | | |

### Test Example: Evaluation of properties of etching composition for texturing crystalline silicon wafer

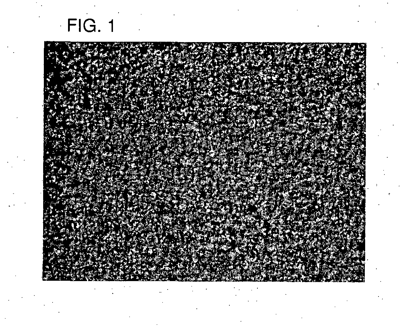

A single-crystal silicon wafer was immersed in each of the etching compositions for texturing a crystalline silicon wafer of Examples 1 to 12 and Comparative Examples 1 to 4. In this case, texturing was performed under conditions of 80°C and 30 minutes. The texture uniformity of each etching composition was evaluated with the naked eye (digital camera), optical microscope, scanning electron microscope (SEM) or the like, and the size of pyramids was measured using SEM. The average reflectance of each etching composition was measured when UV light having a wavelength range of 400 - 800 nm was radiated. The results thereof are shown in Table 2 below and FIGS. 1 to 3.

**[Table 2]**

| Class. | Texture uniformity | Average size of pyramids (*µ*m) | Average reflectance (%) |
|---|---|---|---|
| Ex. 1 | ⊚ | 4 | 12.62 |
| Ex. 2 | ⊚ | 5 | 12.72 |
| Ex. 3 | ⊚ | 4 | 12.42 |
| Ex. 4 | ⊚ | 5 | 12.45 |
| Ex. 5 | ⊚ | 5 | 12.32 |
| Ex. 6 | ⊚ | 4 | 12.19 |
| Ex. 7 | ⊚ | 4 | 12.24 |
| Ex. 8 | ⊚ | 4 | 12.32 |
| Ex. 9 | ⊚ | 5 | 12.17 |
| Ex. 10 | ⊚ | 8 | 12.32 |
| Ex. 11 | ⊚ | 11 | 12.39 |
| Ex. 12 | ⊚ | 7 | 12.24 |
| Comp. Ex. 1 | ○ | 5 | 13.22 |
| Comp. Ex. 2 | × | 10 | 21.13 |
| Comp. Ex. 3 | chemical discolored | | |
| Comp. Ex. 4 | chemical discolored | | |

| | | | |
|---|---|---|---|
| 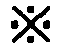 Texture uniformity ⊚: formation of pyramids over the entire surface of wafer ○: formation of pyramids on part of the wafer (the degree to which pyramids were not formed is less than 5%) ×: formation of no pyramids on the wafer (the degree to which pyramids were not formed is more than 90%) | | | |

The term "chemical discolored" indicates that there was no need for a texture test due to the spontaneous change with time upon heating to the texturing temperature.

Referring to Table 2 above and FIGS. 1 to 3, it can be seen that the texture uniformity of the single-crystal silicon wafer using the etching compositions of Examples 1 to 12 is excellent.

However, the etching composition of Comparative Example 1 is problematic because IPA should be continuously added during the texturing process due to its low boiling point, thus deteriorating the texture uniformity (which is caused by the temperature gradient occurring because of the intermittent addition of IPA) and increasing the texturing cost.

Further, the texture uniformity and reflectance of the etching composition of Comparative Example 2 are considerably inferior to those of the etching compositions of Examples 1 to 12. In addition, in the case of the etching compositions of Comparative Examples 3 and 4, there was no need for a texture test due to the spontaneous change with time upon heating to the texturing temperature.

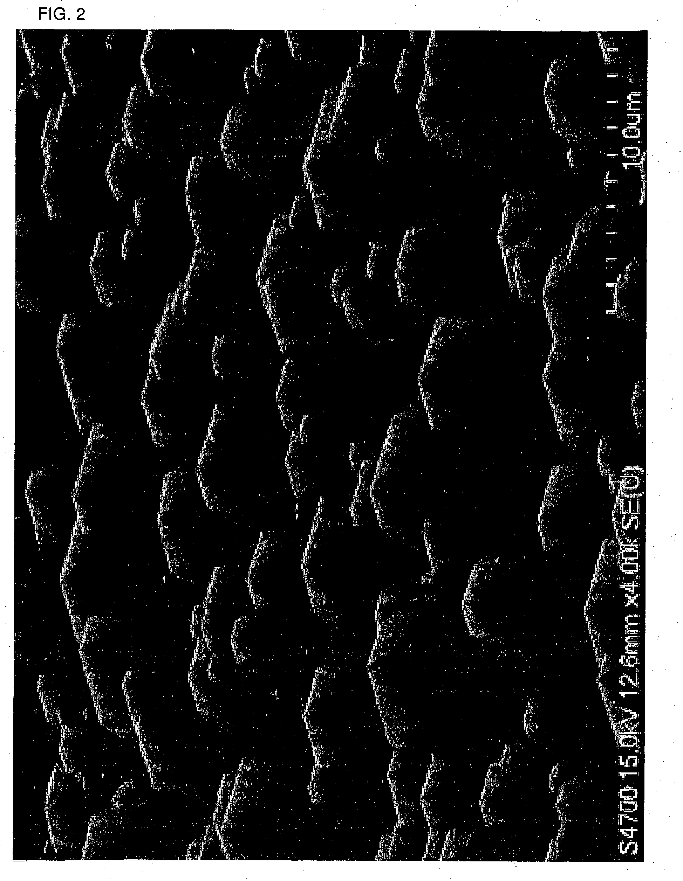

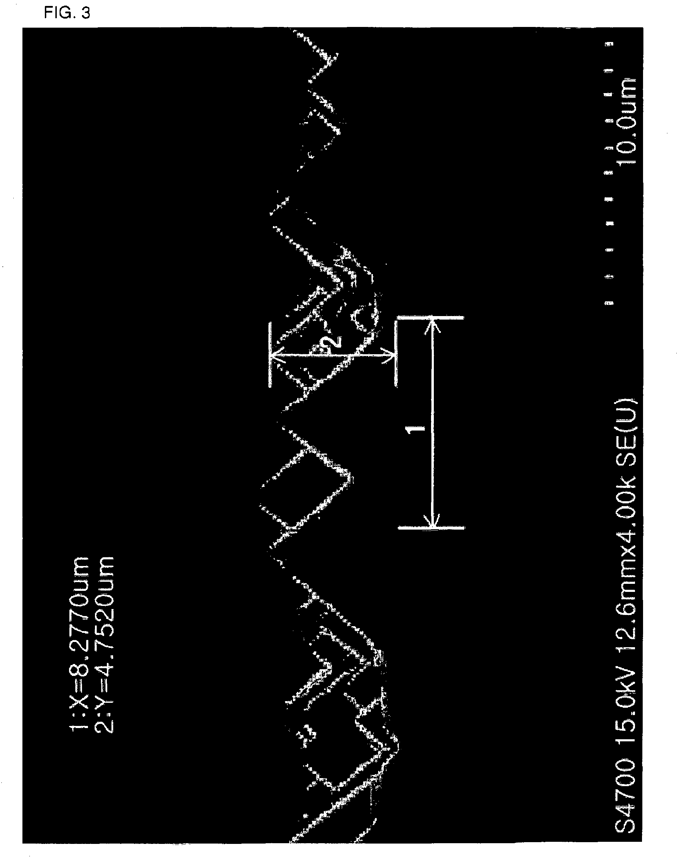

Meanwhile, FIG. 1 is an optical micrograph showing a texture of a crystalline silicon wafer treated with an etching composition of Example 6. FIG. 2 is an SEM photograph showing a surface of a crystalline silicon wafer textured with the etching composition of Example 6. FIG. 3 is an SEM photograph showing a section of a crystalline silicon wafer textured with the etching composition of Example 6. Referring to FIGS. 1 to 3, it can be seen that pyramids were formed over the entire surface of the wafer.

As described above, the etching composition for texturing a crystalline silicon wafer according to the present invention is advantageous in that it can maximize the absorbance of light by forming uniform fine pyramids on a crystalline silicon wafer, in that it can treat a larger number of crystalline silicon wafers compared to a conventional etching composition, thus increasing economic efficiency, and in that it does not need an aerating apparatus and a chemical introducing process, thus reducing the initial production cost and forming uniform and fine pyramids.

## Claims

1. An etching composition for texturing a crystalline silicon wafer, comprising, based on a total amount of the composition:
0.1 to 20 wt% of an alkaline compound, wherein the alkaline compound is one or more selected from the group consisting of potassium hydroxide, sodium hydroxide, ammonium hydroxide, tetrahydroxymethyl ammonium, and tetrahydroxyethyl ammonium;
0.1 to 50 wt% of a cyclic compound having a boiling point of 100°C or more, wherein the cyclic compound is one or more selected from the group consisting of piperazines, morpholines, pyridines, piperidines, piperidones, pyrrolidines, pyrrolidones, imidazolidinones, furans, anilines, toluidines, and lactones, as well as tolyltriazole, 1,2,3-benzotriazole, 1,2,3-triazole, 1,2,4-triazole, 3-amino-1,2,4-triazole, 4-amino-4H-1,2,4-triazole, 1-hydroxybenzotriazole, 1-methylbenzotriazole, 2-methytbenzotriazole, 5-methylbenzotriazole, benzotriazole-5-carbonate, nitrobenzotriazole, and 2-(2H-benzotriazol-2-yl)-4,6-di-tert-butylphenol;
0.000001 to 10 wt% of a fluorine-based surfactant; and
residual water.

2. The etching composition according to claim 1, wherein the cyclic compound having a boiling point of 100°C or more is one or more selected from the group consisting of piperazine, N-methylpiperazine, N-ethylpiperazine, hydroxyethylpiperazine, N-(2-aminoethyl)piperazine, N,N'-dimethylpiperazine, morpholine, N-methylmorpholine, N-ethylmorpholine, N-phenylmorpholine, N-cocomorpholine, N-(2-aminoethyl)morpholine, N-(2-cyanoethyl)morpholine, N-(2-hydroxyethyl)morpholine, N-(2-hydroxypropyl)morpholine, N-acetylmorpholine, N-formylmorpholine, N-methymorpholine-N-oxide, picoline, N-methylpiperidine, 3,5-dimethylpiperidine, N-ethylpiperidine, N-(2-hydroxyethyl)piperidine, N-methyl-4-piperidone, N-vinyl-2-piperidone, N-methylpyrrolidine, N-methylpyrrolidone, N-ethyl-2-pyrrolidone, N-isopropyl-2-pyrrolidone, N-butyl-2-pyrrolidone, N-tert-butyl-2-pyrrolidone, N-hexyl-2-pyrrolidone, N-octyl-2-pyrrolidone, N-benzyl-2-pyrrolidone, N-cyclohexyl-2-pyrrolidone, N-vinly-2-pyrrolidone, N-(2-hydroxyethyl)-2-pyrrolidone, N-(2-methoxyethyl)-2-pyrrolidone, N-(2-methoxypropyl)-2-pyrrolidone, N-(2-ethoxyethyl)-2-pyrrolidone, N-methylimidazolidinone, dimethylimidazolidinone, N-(2-hydroxyethyl)-ethyleneurea, tetrahydrofurfurylalcohol, N-methylaniline, N-ethylaniline, N,N-dimethylaniline, N-(2-hydroxyethyl)aniline, N,N-bis-(2-hydroxyethyl)aniline, N-ethyl-N-(2-hydroxyethyl)aniline, N,N-diethyl-o-toluidine, N-ethyl-N-(2-hydroxyethyl)-m-toluidine, dimethylbenzylamine, γ-butyrolactone,.

3. The etching composition according to claim 1, wherein the fluorine-based surfactant is one or more selected from the group consisting of anionic fluorine-based surfactants including perfluoroalkyl carboxylates, perfluoroalkyl sulfonates, perfluoroalkyl sulfates, and perfluoroalkyl phosphates; cationic fluorine-based surfactants including perfluoroalkyl amines and perfluoroalkyl quaternary ammoniums; amphoteric ionic fluorine-based surfactants including perfluoroalkyl carboxybetaine and perfluoroalkyl sulfobetaine; and nonionic fluorine-based surfactants including fluoroalkyl polyoxyethylene and perfluoroalkyl polyoxyethylene.

4. The etching composition according to claim 1, wherein the cyclic compound has a boiling point of 150°C to 400°C.

5. The etching composition according to claim 1, further comprising a silica-containing compound in an amount of 0.00001 to 10 wt%, based on the total amount of the composition.

6. The etching composition according to claim 5, wherein the silica-containing compound is one or more selected from the group consisting of powdered silica, silica-containing colloidal solutions, and liquid metal silicates.

7. A method of etching a crystalline silicon wafer by dipping and/or spraying the crystalline silicon wafer at 50 to 100°C for 30 seconds to 60 minutes using the etching composition of any one of claims 1 to 6.

## Patentansprüche

1. Ätzzusammensetzung zur Texturierung einer kristallinen Siliciumscheibe, die bezogen auf eine Gesamtmenge der Zusammensetzung Folgendes umfasst:
0,1 bis 20 Gew.-% einer alkalischen Verbindung, wobei es sich bei der alkalischen Verbindung um eine oder mehrere aus der aus Kaliumhydroxid, Natriumhydroxid, Ammoniumhydroxid, Tetrahydroxymethylammonium und Tetrahydroxyethylammonium bestehenden Gruppe ausgewählte Verbindungen handelt,
0,1 bis 50 Gew.-% einer Ringverbindung mit einem Siedepunkt von 100°C oder mehr, wobei es sich bei der Ringverbindung um eine oder mehrere aus der aus Piperazinen, Morpholinen, Pyridinen, Piperidinen, Piperidonen, Pyrrolidinen, Pyrrolidonen, Imidazolidinonen, Furanen, Anilinen, Toluidinen und Lactonen sowie Tolyltriazol, 1,2,3-Benzotriazol, 1,2,3-Triazol, 1,2,4-Triazol, 3-Amino-1,2,4-Triazol, 4-Amino-4H-1,2,4-Triazol, 1-Hydroxybenzotriazol, 1-Methylbenzotriazol, 2-Methylbenzotriazol, 5-Methylbenzotriazol, Benzotriazol-5-Carbonat, Nitrobenzotriazol und 2-(2H-Benzotriazol-2-yl)-4,6-di-tert-butylphenol bestehenden Gruppe ausgewählte Verbindungen handelt,
0,000001 bis 10 Gew.-% eines oberflächenaktiven Stoffes auf Fluorbasis und zum Rest Wasser.

2. Ätzzusammensetzung nach Anspruch 1, wobei es sich bei der Ringverbindung mit einem Siedepunkt von 100°C oder mehr um eine oder mehrere aus der aus Piperazin, N-Methylpiperazin, N-Ethylpiperazin, Hydroxyethylpiperazin, N-(2-Aminoethyl)piperazin, N, N'-Dimethylpiperazin, Morpholin, N-Methylmorpholin, N-Ethylmorpholin, N-Phenylmorpholin, N-Cocomorpholin, N-(2-Aminoethyl)morpholin, N-(2-Cyanethyl)morpholin, N-(2-Hydroxyethyl)morpholin, N-(2-Hydroxypropyl)morpholin, N-Acetylmorpholin, N-Formylmorpholin, N-Methylmorpholin-N-oxid, Picolin, N-Methylpiperidin, 3,5-Dimethylpiperidin, N-Ethylpiperidin, N-(2-Hydroxyethyl)piperidin, N-Methyl-4-piperidon, N-Vinyl-2-piperidon, N-Methylpyrrolidin, N-Methylpyrrolidon, N-Ethyl-2-pyrrolidon, N-Isopropyl-2-pyrrolidon, N-Butyl-2-pyrrolidon, N-tert-Butyl-2-pyrrolidon, N-Hexyl-2-pyrrolidon, N-Octyl-2-pyrrolidon, N-Benzyl-2-pyrrolidon, N-Cyclohexyl-2-pyrrolidon, N-Vinyl-2-pyrrolidon, N-(2-Hydroxyethyl)-2-pyrrolidon, N-(2-Methoxyethyl)-2-pyrrolidon, N-(2-Methoxypropyl)-2-pyrrolidon, N-(2-Ethoxyethyl)-2-pyrrolidon, N-Methylimidazolidinon, Dimethylimidazolidinon, N-(2-Hydroxyethyl)-Ethylenharnstoff, Tetrahydrofurfurylalkohol, N-Methylanilin, N-Ethylanilin, N,N-Dimethylanilin, N-(2-Hydroxyethyl)anilin, N,N-bis-(2-Hydroxyethyl)anilin, N-Ethyl-N-(2-hydroxyethyl)anilin, N,N-Diethyl-o-toluidin, N-Ethyl-N-(2-hydroxyethyl)-m-toluidin, Dimethylbenzylamin, y-Butyrolacton bestehenden Gruppe ausgewählte handelt.

3. Ätzzusammensetzung nach Anspruch 1, wobei es sich bei dem oberflächenaktiven Stoff auf Fluorbasis um einen oder mehrere aus der aus anionischen oberflächenaktiven Stoffen auf Fluorbasis einschließlich Perfluoralkylcarboxylaten, Perfluoralkylsulfonaten, Perfluoralkylsulfaten und Perfluoralkylphosphaten, kationischen oberflächenaktiven Stoffen auf Fluorbasis einschließlich Perfluoralkylaminen und quartären Perfluoralkylammoniumverbindungen, amphoteren ionischen oberflächenaktiven Stoffen auf Fluorbasis einschließlich Perfluoralkylcarboxybetain und Perfluoralkylsulfobetain und nichtionischen oberflächenaktiven Stoffen auf Fluorbasis einschließlich Fluoralkylpolyoxyethylen und Perfluoralkylpolyoxyethylen bestehenden Gruppe ausgewählten Stoffe handelt.

4. Ätzzusammensetzung nach Anspruch 1, wobei die Ringverbindung einen Siedepunkt von 150°C bis 400°C hat.

5. Ätzzusammensetzung nach Anspruch 1, ferner mit einer siliciumdioxidhaltigen Verbindung in einer Menge von 0,00001 bis 10 Gew.-% bezogen auf die Gesamtmenge der Zusammensetzung.

6. Ätzzusammensetzung nach Anspruch 5, wobei es sich bei der siliciumdioxidhaltigen Verbindung um eine oder mehrere aus der aus pulverisiertem Siliciumdioxid, siliciumdioxidhaltigen kolloidalen Lösungen und Flüssigmetallsilicaten bestehenden Gruppe ausgewählte Verbindungen handelt.

7. Verfahren zum Ätzen einer kristallinen Siliciumscheibe, bei dem die kristalline Siliciumscheibe 30 Sekunden bis 60 Minuten lang bei 50 bis 100°C unter Verwendung der Ätzzusammensetzung nach einem der Ansprüche 1 bis 6 eingetaucht und/oder besprüht wird.

## Revendications

1. Composition de gravure pour texturer une tranche en silicium cristallin, comprenant sur la base d'une quantité totale de la composition :
0,1 à 20 % en poids d'un composé alcalin, le composé alcalin étant un ou plusieurs choisis dans le groupe constitué d'hydroxyde de potassium, d'hydroxyde de sodium, d'hydroxyde d'ammonium, de tétrahydroxy-méthylammonium et de tétrahydroxyéthylammonium ;
0,1 à 50 % en poids d'un composé cyclique présentant un point d'ébullition de 100°C ou plus, le composé cyclique étant un ou plusieurs choisis dans le groupe constitué de pipérazines, de morpholines, de pyridines, de pipéridines, de pipéridones, de pyrrolidines, de pyrrolidones, d'imidazolidinones, de furanes, d'anilines, de toluidines et de lactones ainsi que de tolyltriazole, de 1,2,3-benzotriazole, de 1,2,3-triazole, de 1,2,4-triazole, de 3-amino-1,2,4-triazole, de 4-amino-4H-1,2,4-triazole, de 1-hydroxybenzotriazole, de 1-méthylbenzotriazole, de 2-méthylbenzotriazole, de 5-méthylbenzotriazole, de benzotriazole-5-carbonate, de nitrobenzotriazole, et de 2-(2H-benzotriazole-2-yl)-4,6-di-tert-butylphénole ;
0,000001 à 10 % en poids d'un agent de surface à base de fluorine ; et
de l'eau résiduelle.

2. Composition de gravure selon la revendication 1, dans laquelle le composé cyclique présentant un point d'ébullition de 100°C ou plus est un ou plusieurs choisis dans le groupe constitué de pipérazine, de N-méthylpipérazine, de N-éthylpipérazine, d'hydroxyéthylpipérazine, de N-(2-aminoéthyl)pipérazine, de N,N'-diméthylpipérazine, de morpholine, de N-méthylmorpholine, de N-éthylmorpholine, de N-phénylmorpholine, de N-cocomorpholine, de N-(2-aminoéthyl)morpholine, de N-(2-cyanoéthyl)morpholine, de N-(2-hydroxyéthyl)morpholine, de N-(2-hydroxypropyl)morpholine, de N-acétyl-morpholine, de N-formylmorpholine, de N-méthylmorpholine-N-oxyde, de picoline, de N-méthylpipéridine, de 3,5-diméthylpipéridine, de N-éthylpipéridine, de N-(2-hydroxyéthyl)pipéridine, de N-méthyl-4-pipéridone, de N-vinyl-2-pipéridone, de N-méthylpyrrolidine, de N-méthylpyrrolidone, de N-éthyl-2-pyrrolidone, de N-isopropyl-2-pyrrolidone, de N-butyl-2-pyrrolidone, de N-tert-butyl-2-pyrrolidone, de N-hexyl-2-pyrrolidone, de N-octyl-2-pyrrolidone, de N-benzyl-2-pyrrolidone, de N-cyclohexyl-2-pyrrolidone, de N-vinyl-2-pyrrolidone, de N-(2-hydroxyéthyl)-2-pyrrolidone, de N-(2-méthoxyéthyl)-2-pyrrolidone, de N-(2-méthoxypropyl)-2-pyrrolidone, de N-(2-éthoxyéthyl)-2-pyrrolidone, de N-méthylimidazolidinone, de diméthylimidazolidinone, de N-(2-hydroxyéthyl)-éthylène-urée, d'alcool tétrahydrofurfurylique, de N-méthylaniline, de N-éthylaniline, de N,N-diméthylaniline, de N-(2-hydroxyéthyl)aniline, de N,N-bis-(2-hydroxyéthyl)aniline, de N-éthyl-N-(2-hydroxyéthyl)aniline, de N,N-diéthyl-o-toluidine, de N-éthyl-N-(2-hydroxyéthyl)-m-toluidine, de diméthylbenzylamine, de y-butyrolactone.

3. Composition de gravure selon la revendication 1, dans laquelle l'agent de surface à base de fluorine est un ou plusieurs choisis parmi le groupe constitué d'agents de surface anioniques à base de fluorine y compris les carboxylates de perfluoroalkyle, les sulfonates de perfluoroalkyle, les sulfates de perfluoroalkyle, et les phosphates de perfluoroalkyle, d'agents de surface cationiques à base de fluorine y compris les amines de perfluoroalkyle et les ammoniums quartenaires de perfluoroalkyle, d'agents de surface amphotères ioniques à base de fluorine y compris la carboxybétaïne de perfluoroalkyle et la sulfobétaïne de perfluoroalkyle, et d'agents de surface non-ioniques à base de fluorine y compris le polyoxyéthylène de fluoroalkyle et le polyoxyéthylène de perfluoroalkyle.

4. Composition de gravure selon la revendication 1, dans laquelle le composé cyclique présente un point d'ébullition de 150°C à 400°C.

5. Composition de gravure selon la revendication 1, comprenant en outre un composé contenant du dioxyde de silicium dans une quantité de 0,00001 à 10 % en poids par rapport à la quantité totale de la composition.

6. Composition de gravure selon la revendication 5, le composé contenant du dioxyde de silicium étant un ou plusieurs choisis dans le groupe constitué de dioxyde de silicium en poudre, de solutions colloïdales contenant du dioxyde de silicium, et de silicates de métaux liquides.

7. Procédé de gravure d'une tranche en silicium cristallin en trempant et/ou en pulvérisant la tranche en silicium cristallin entre 30 secondes et 60 minutes à une température de 50 à 100°C en utilisant la composition de gravure selon l'une des revendications 1 à 6.
